# EUROPÄISCHE PATENTANMELDUNG

(11) **EP 2 369 153 A2**
(43) Veröffentlichungstag der Anmeldung: **28.09.2011**
(21) Anmeldenummer: 10187515.1
(22) Anmeldetag: 14.10.2010
(51) Int. Cl.: F01P 5/04

(54) **Elektrisches Steuergerät**

(30) Priorität: 30.10.2009 DE 102009046189
(71) Anmelder: Robert Bosch GmbH, 70442 Stuttgart (DE)
(72) Erfinder: Riehl, Guenther, 77815, Buehl (DE)

(57) **Zusammenfassung**

Ein elektrisches Steuergerät für ein Motorkühlmodul hat ein elektrisches Anschlusselement zur nichtlösbaren Verbindung mit einer elektrischen Leitung eines elektrischen Verbrauchers und eine abgedichtete elektrische Steckverbindung zur lösbaren Verbindung mit einer Stromversorgung, wobei die Verbindung der elektrischen Leitung mit dem elektrischen Anschlusselement derart ausgeführt ist, dass eine mangelnde Dichtheit der Verbindung eine Dichtheit des Steuergeräts nicht beeinflusst

## Beschreibung

### Stand der Technik

Steuergeräte, insbesondere zum Einsatz in einem Kraftfahrzeug, können zur Montage in einer elektrischen Leitung von einer Stromquelle zu einem elektrischen Verbraucher ausgelegt sein. Diese Ausführungsform bietet sich insbesondere dann an, wenn Betriebsbedingungen unmittelbar am elektrischen Verbraucher ungünstig sind, wie beispielsweise bei einem thermisch und durch Vibrationen hoch belasteten Lüftermotor für einen Radiator des Kraftfahrzeugs. Eine Verbindung des elektrischen Steuermoduls mit elektrischen Leitungen zum elektrischen Verbraucher bzw. zur Stromquelle ist bezüglich einer Qualität der Verbindungen und bzgl. den damit verbunden Kosten problematisch.

Der Erfindung liegt die Aufgabe zugrunde, eine Technik anzugeben, mittels derer einen qualitativ hochwertige und kostengünstige Verbindung eines elektrischen Steuergerätes bereitgestellt wird.

### Offenbarung der Erfindung

Die Erfindung löst dieses Aufgabe durch ein elektrisches Steuergerät nach Anspruch 1, ein elektrisches Verbrauchersystem nach Anspruch 7 und ein Verfahren nach Anspruch 9. Unteransprüche geben Ausführungsformen wieder.

Erfindungsgemäß weist ein elektrisches Steuergerät für ein Motorkühlmodul eine abgedichtete elektrische Steckverbindung zur lösbaren Verbindung mit einer Stromversorgung und ein elektrisches Anschlusselement zur nichtlösbaren Verbindung mit einer elektrischen Leitung eines elektrischen Verbrauchers auf. Dabei ist die Verbindung der elektrischen Leitung mit dem elektrischen Anschlusselement derart ausgeführt, dass eine mangelnde Dichtheit der Verbindung eine Dichtheit des Steuergeräts nicht beeinflusst. So wird sicher gestellt, dass Feuchtigkeit und Spritzwasser von Bauelementen des Steuergeräts und von Kontakten der elektrischen Steckverbindung fern gehalten werden, so dass eine Beeinflussung der Betriebssicherheit des Steuermoduls vermieden wird. Gleichzeitig kann auf eine aufwendige Abdichtung der Verbindung der elektrischen Leitung mit dem elektrischen Anschlusselement verzichtet werden, da die elektrischen Signale dieser Verbindung unempfindlich gegenüber Feuchtigkeit und Spritzwasser sind. Üblicherweise ist eine Verbindung der elektrischen Leitung mit dem Motorkühlmodul aus den gleichen Gründen nicht abgedichtet.

Dadurch ist es möglich, eine schnell zu installierende, nichtlösbare Verbindung des Anschlusselements mit der elektrischen Leitung zu verwenden, beispielsweise eine Schweiß- oder Schneid-Klemm-Verbindung. So kann eine Fertigung von Steuergeräten mit bereits verbundenen Motorkühlmodulen flexibler und kostengünstiger gestaltet werden.

Eine Abdichtung im Sinne dieses Dokuments bezeichnet eine Anordnung, die für Flüssigkeiten undurchdringlich ist, die im Bereich der Anordnung bei bestimmungsgemäßem Gebrauch erwartet werden können und die eine Funktion oder Betriebssicherheit der beschriebenen Vorrichtung oder eines ihrer Teile beeinträchtigen können. Insbesondere sind die hier genannten Dichtungen oder Abdichtungen dazu geeignet, verunreinigtes Spritzwasser und Kondenswasser von Strom führenden Teilen der Vorrichtung und an die Vorrichtung angeschlossenen Elementen fern zu halten, so dass unerwünschte Stromflüsse vermieden werden.

Das elektrische Steuergerät kann ein Gehäuse mit einer Aussparung aufweisen, in deren Bereich ein Anschlussträger für das elektrische Anschlusselement und die elektrische Steckverbindung vorgesehen ist, wobei eine erste Dichtung zwischen dem Anschlussträger und dem Gehäuse vorgesehen ist. Der Anschlussträger erleichtert eine Führung elektrischer Verbindungen zwischen der lösbaren elektrischen Steckverbindung und dem elektrischen Anschlusselement. Zudem erlaubt die räumliche Nähe der lösbaren elektrischen Steckverbindung zum elektrischen Anschlusselement eine vereinfachte Abdichtung des Anschlussträgers zum Gehäuse des elektrischen Steuergeräts, so dass ein verbesserter Schutz gegen Umwelteinflüsse leicht implementierbar ist.

Eine zweite Dichtung kann zwischen dem elektrischen Anschlusselement und dem Anschlussträger vorgesehen sein, so dass Feuchtigkeit, die in den Bereich des Anschlussträgers vorgedrungen ist, von einer Innenseite des Gehäuses fern gehalten wird.

Die Erfindung umfasst auch ein System aus dem beschriebenen elektrischen Steuergerät und einem elektrischen Verbraucher, der mittels einer elektrischen Leitung mit dem elektrischen Steuergerät verbunden ist.

Ferner umfasst die Erfindung ein Verfahren zur Verbindung des beschriebenen elektrischen Steuergeräts mit dem elektrischen Verbraucher.

### Kurze Beschreibung der Zeichnungen

Die Erfindung wird nun mit Bezug auf die beigefügten Zeichnungen beschrieben, in denen:
Figur 1 eine schematische Ansicht eines Längsschnitts durch ein elektrisches Steuergerät;
Figur 1b eine Variation des elektrischen Anschlusselements aus Figur 1;
Figur 2 ein elektrisches Verbrauchersystem mit dem elektrischen Steuergerät aus Figur 1; und
Figur 3 ein Ablaufdiagramm eines Verfahrens zum elektrischen Verbinden des elektrischen Steuergeräts aus Figur 1
darstellt.

### Genaue Beschreibung von Ausführungsbeispielen

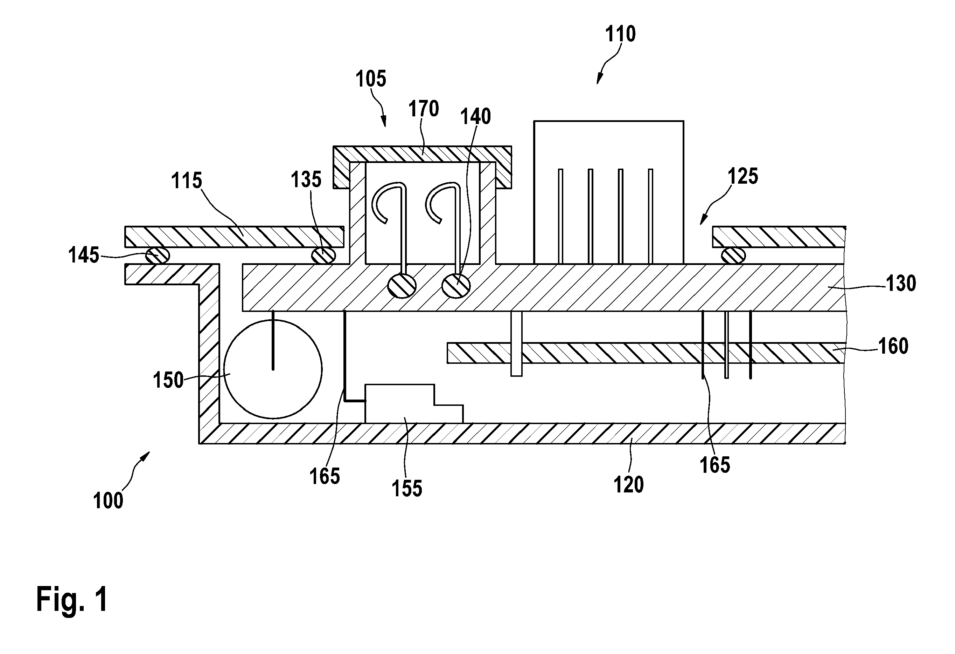

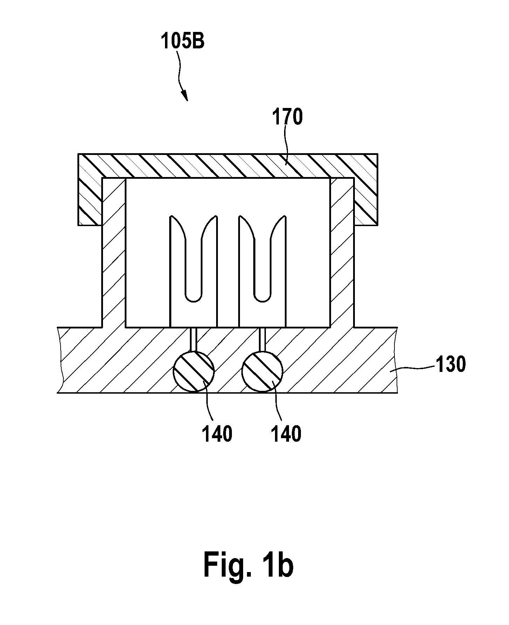

Figur 1 zeigt einen schematischen Längsschnitt durch ein elektrisches Steuergerät 100. Das elektrische Steuergerät 100 umfasst ein Gehäuseoberteil 115 und ein Gehäuseunterteil 120, wobei die Gehäuseteile 115, 120 einen Anschlussträger 130, einen Kondensator 150, einen Leistungstransistor 155 und eine Leiterplatte 160 umschließen. Das Gehäuseoberteil 115 weist eine Aussparung 125 auf, die auf der Innenseite der Gehäuseteile 115, 120 durch den Anschlussträger 130 abgedeckt ist. Der Anschlussträger 130 ist mittels einer ersten Dichtung 135 gegenüber dem Gehäuseoberteil 115 abgedichtet. Die erste Dichtung 135 verläuft auf der Innenseite des Gehäuseoberteils 115 um die Aussparung 125 herum und ist zwischen dem Gehäuseoberteil 115 und dem Anschlussträger 130 zusammengepresst. Die erste Dichtung 135 kann beispielsweise in Form einer Gummi- oder Kunststoffdichtung als Flach- oder Profildichtung ausgeführt sein. Alternativ kann die erste Dichtung 135 durch Verkleben oder durch eine Dichtmasse hergestellt sein.

Der Anschlussträger 130 trägt ein elektrisches Anschlusselement 105 und eine elektrische Steckverbindung 110. Das elektrische Anschlusselement 105 ist mittels einer zweiten Dichtung 140 gegenüber dem Anschlussträger 130 abgedichtet. Die zweite Dichtung 140 kann beispielsweise durch Iokales Vergießen, Verschmelzen oder Verkleben des elektrischen Anschlusselements 105 mit dem Anschlussträger 130 implementiert sein. In einer weiteren Ausführungsform können das elektrische Anschlusselement 105 und der Anschlussträger 130 auch gemeinsam mit Kunststoff umspritzt sein, so dass eine wasserdichte Verbindung zwischen den beiden Elementen bestehts. Vorzugsweise weist das elektrische Anschlusselement 105 einen Spritzschutz 170 auf, der beispielsweise in Form einer aufgesteckten oder angeklemmten Abdeckung, vorzugsweise aus einem Kunststoff, besteht.

Das Gehäuseoberteil 115 ist mittels einer dritten Dichtung 145 gegenüber dem Gehäuseunterteil 120 abgedichtet. Dazu können am Gehäuseoberteil 115 und dem Gehäuseunterteil 120 einander gegenüberliegende Flansche ausgebildet sein, zwischen denen die dritte Dichtung 145 zusammengepresst ist. Die dritte Dichtung 145 kann beispielsweise in Form eines Kunststoffprofils oder einer Flachdichtung, etwa aus einem Gummi oder aus Dichtpapier, ausgeführt sein.

Der Anschlussträger 130 kann als Stanzgitter ausgeführt sein. Dabei ist ein Blech derart gestanzt, dass die verbleibenden Elemente die Funktion von Leiterbahnen erfüllen. Insbesondere ist es bevorzugt, dass der Anschlussträger 130 aus mit einem Kunststoff ummantelten Stanzgitter oder als mit Kunststoff ummanteltes Stanzgitterpaket mit Durchkontaktierungen ausgebildet ist. Leitende Strukturen des Anschlussträgers 130 können einzelne Anschlüsse des elektrischen Anschlusselements 105, der elektrischen Steckverbindung 110 und der Kontaktierung 165 miteinander verbinden. Auch Kontakte von Leistungs-Bauelementen wie des Kondensators 150 oder des Leistungstransistors 155 können mittels des Stanzgitters oder Stanzgitterpakets kontaktiert sein. Durch Verwendung eines Stanzgitters können solche Verbindungen, die durch einen im Betrieb des elektrischen Steuergeräts 100 fließenden Strom hoch belastet sind, kurz und mit einem niedrigen Gesamtwiderstand ausgelegt sein.

Die Kontaktierungen 165 verbinden den Anschlussträger 130 mit Leistungs-Bauelementen wie dem Kondensator 150 und dem Leistungstransistor 155, und mit der Leiterplatte 160, auf der weitere elektronische Bauelemente angeordnet sind, die eine Steuerfunktionalität des elektrischen Steuergeräts 100 realisieren.

Leistungs-Bauelemente wie der Kondensator 150 und der Leistungstransistor 155 können in Kontakt mit einem der Gehäuseteile 115, 120 angeordnet sein, so dass das entsprechende Gehäuseteil 115, 120 als Kühlkörper wirken kann. Vorzugsweise sind das Gehäuseoberteil 115 und das Gehäuseunterteil 120 aus einem Blech hergestellt und derart geformt, dass Leistungs-Bauelemente wie der Kondensator 150 und der Leistungstransistor 155 sich auf der Innenseite des betreffenden Gehäuseteils 115, 120 zur optimalen Wärmeübertragung an dessen Oberfläche anschmiegen kann und gleichzeitig auf der Außenseite des entsprechenden Gehäuseteils 115, 120 eine Abgabe von Wärme an ein umgebendes Medium, beispielsweise mittels Kühlrippen, unterstützt ist.

Figur 1 b zeigt eine Variation des elektrischen Anschlusselements 105 aus Figur 1. Das elektrische Anschlusselement 105 ist hier durch die Schneidklemme 105b ersetzt, in die isolierte Drähte oder Drahtkabel derart eingelegt werden können, dass ein Schneid-Klemmelement jeweils die Isolierung eines Drahtkabels durchschneidet und anschließend durch Klemmsitz an dem Drahtkabel einen elektrischen Kontakt herstellt. Der Vorgang des Schneidens und Klemmens kann durch den Spritzschutz 170 unterstützt sein, indem dieser beispielsweise über eine kraftschlüssige mehrstufige Rastvorrichtung an der Schneidklemme 105b verfügt. Die Schneidklemme 105b ist wie das elektrischen Anschlusselement 105 in Figur 1 mittels der zweiten Dichtung 140 gegenüber dem Anschlussträger 130 abgedichtet.

Das elektrische Anschlusselement 105 und die Schneidklemme 105b sind zur nichtlösbaren Verbindung mit einer elektrischen Leitung eingerichtet. Bei einer nichtlösbaren Verbindung ist ein Lösen nicht von vornherein ausgeschlossen, sondern lediglich nicht vorgesehen und kann eine Beschädigung oder Zerstörung des Verbindungselements nach sich ziehen. Das elektrische Anschlusselement 105 ist beispielsweise derart dimensioniert, dass es eine thermische Belastung durch ein Verschweißen nur ein einziges Mal ohne Schäden an seiner Struktur oder Form übersteht. Wird eine Verschweißung mit dem elektrischen Anschlusselements 105 wieder gelöst, so ist das elektrische Anschlusselement 105 im Allgemeinen nicht für eine weitere Verbindung verwendbar. In entsprechender Weise ist die Schneidklemme 105b nur zur einmaligen Durchtrennung einer Isolation und Herstellung eines Klemmsitzes mit einem Draht oder Drahtkabel ausgelegt. Bei einer erneuten Verwendung kann die Schneid- und/oder die Klemmfunktion der Schneidklemme 105b nicht ausreichend für eine sichere Verbindung sein.

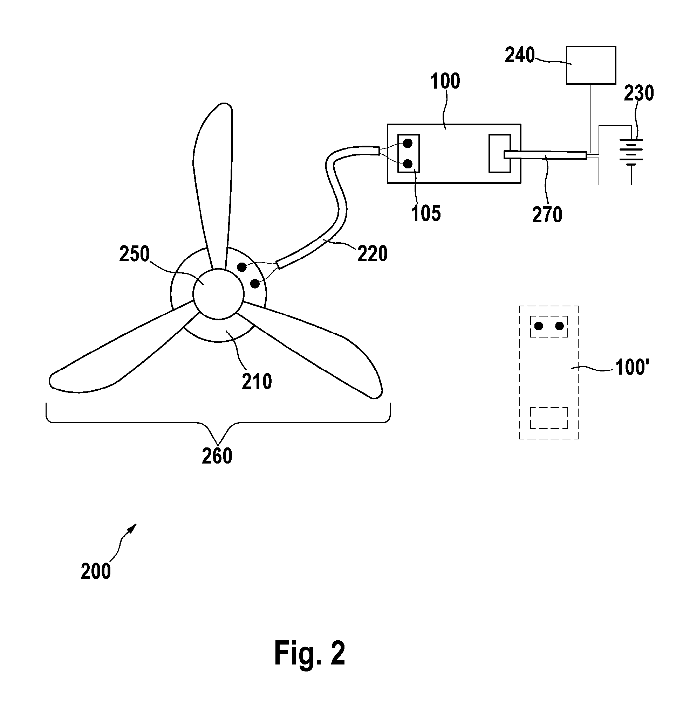

Figur 2 zeigt ein elektrisches Verbrauchersystem 200. Das elektrische Verbrauchersystem 200 umfasst das oben beschriebene elektrische Steuergerät 100, einen elektrischen Verbraucher 210 und eine elektrische Leitung 220. Die elektrische Leitung 220 verbindet den elektrischen Verbraucher 210 mit dem elektrischen Steuergerät 100.

Das elektrische Steuergerät 100 ist mittels einer elektrischen Leitung 270 mit einer Stromversorgung 230 und einem weiteren Steuergerät 240 verbunden. Die Stromversorgung 230 stellt elektrische Energie zur Versorgung des elektrischen Verbrauchers 210 bereit. Das weitere Steuergerät 240 übermittelt Vorgaben an das elektrische Steuergerät 100, beispielsweise, mit welcher Leistung oder welcher Drehzahl der elektrische Verbraucher 210 betrieben werden soll. Eine Informationsübermittlung zwischen den Steuergeräten 100 und 240 kann eine Steuerleitung innerhalb der elektrischen Leitung 270 umfassen, die weitaus anfälliger gegen unerwünschte Stromflüsse als eine Energieübertragungsleitung ist. Dies rührt daher, dass die Signale der Steuerleitung üblicherweise mit geringeren Spannungen und Strömen übertragen werden als zur Energieversorgung des Steuergeräts 100 verwendet werden. Signaleingänge der Steuergeräte 100 und 240 sind dementsprechend empfindlich und sprechen bereits auf kleine Signalschwankungen an.

Das elektrische Steuergerät ist nicht unmittelbar am elektrischen Verbraucher 210 angeordnet, um einerseits die Raumanforderungen des elektrischen Verbrauchers 210 nicht zu vergrößern und andererseits um ungünstige Betriebsbedingungen, etwa eine hohe thermische Belastung, Feuchtigkeit, eine starke Verschmutzung und Vibrationen, zu vermeiden. Solche Bedingungen sind beispielsweise innerhalb des elektrischen Verbrauchers 210 anzutreffen, wo insbesondere eine Verunreinigung durch Kohlestaub von Kontaktbürsten des Verbrauchers 210 unerwünschte Stromflüsse begünstigen können.

Das elektrische Steuergerät 100 ist andererseits nicht mit dem Steuergerät 240 integriert ausgeführt, um ein separat handhabbares Verbrauchersystem 200 bereitzustellen, das eine durch den elektrischen Verbraucher 210 bestimmte Funktionalität eigenständig implementiert, und das gegebenenfalls in unterschiedlichen Umgebungen, beispielsweise Kraftfahrzeugen unterschiedlicher Bauarten, verbaut werden kann.

Der elektrische Verbraucher 210 ist zusammen mit einer Luftschraube 250 Teil eines Lüftermoduls 260. Das Lüftermodul 260 belüftet beispielsweise einen Radiator eines Kraftfahrzeugs, wobei der Radiator etwa Teil eines Kühlmittelkreislaufs eines Verbrennungsmotors des Kraftfahrzeugs ist. In einer Ausführungsform umfasst das elektrische Steuergerät 100 wenigstens einen Sensor, etwa einen Temperatursensor, um einen Ist-Wert zu bestimmen und den elektrischen Verbraucher 210 in Abhängigkeit eines Unterschiedes des Ist-Wertes zu einem vom weiteren Steuergerät 240 übermittelten Soll-Wert, beispielsweise mittels Pulsmodulation zu steuern.

Das elektrische Steuergerät 100 kann in einer anderen Ausführung des elektrischen Verbrauchersystems 200 an einer anderen Position bezüglich des Lüftermoduls 260 montiert werden, wie in der Zeichnung als gestricheltes elektrisches Steuergerät 100' dargestellt ist. Vom elektrischen Verbrauchersystem 200 nicht umfasste elektrische Leitungen 220, 270 zwischen dem elektrischen Steuergerät 100 bzw. 100' und der Stromversorgung 230 und dem weiteren Steuergerät 240 sind gemäß der jeweiligen Position des elektrischen Steuergeräts 100 bzw. 100' konfektioniert.

Um eine Anordnung des elektrischen Verbrauchersystems 200 mit der alternativen Einbaulage des elektrischen Steuergeräts 100' zu unterstützten, kann die elektrische Leitung 220 entsprechend abgelängt und geformt und mit dem elektrischen Steuergerät 100' verbunden sein. So können mit nur geringen Änderungen elektrische Verbrauchersysteme 200 bereitgestellt werden, die im Wesentlichen aus den gleichen Komponenten 100 bzw. 100', 210 und 220 bestehen, ohne an einer Fertigungseinrichtung oder einem Fertigungsverfahren von elektrischen Verbrauchersystemen 200 tiefgreifende Änderungen durchzuführen oder eine aufwendige Verbindungstechnik der elektrischen Leitung 220 mit dem elektrischen Verbraucher 210 und/oder dem elektrischen Steuergerät 100 bzw. 100' zu verwenden.

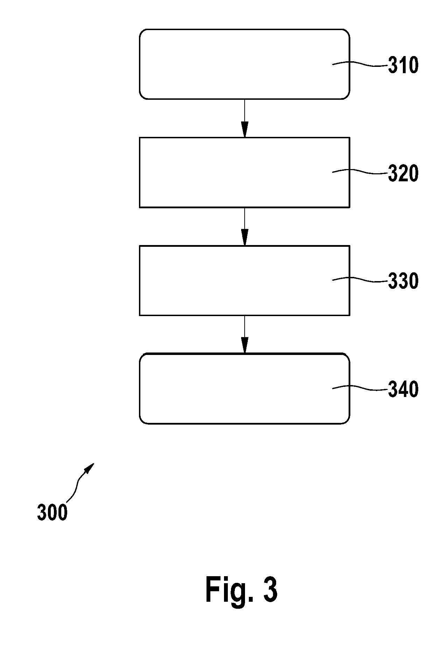

Figur 3 zeigt ein Ablaufdiagramm eines Verfahrens 300 zum elektrischen Verbinden des elektrischen Steuergeräts 100 aus Figur 1 mit dem elektrischen Verbraucher 210 aus Figur 2. In einem ersten Schritt 310 befindet sich das Verfahren 300 im Startzustand. Danach wird in einem Schritt 320 die elektrische Leitung 220 mit dem elektrischen Verbraucher 210 verbunden. Diese Verbindung kann beispielsweise ein Verschweißen, Verlöten, Verschrauben, Vernieten oder eine andere bekannte Verbindungstechnik umfassen. Vorzugsweise wird auch hier eine kostengünstige und betriebssichere nichtlösbare Verbindung wie Verschweißen verwendet. In diesem Schritt kann auch eine Zugentlastung der elektrischen Leitung 220 am elektrischen Verbraucher 210 angebracht werden.

In einem Schritt 330 wird die elektrische Leitung 220 nichtlösbar mit dem elektrischen Steuergerät 100 verbunden. Dabei kann insbesondere Gebrauch gemacht werden von einer Schweiß- oder Schneid-Klemm-Verbindung. Zusätzlich kann eine Zugentlastung der elektrischen Leitung 220 am elektrischen Verbraucher 100 angebracht werden und der Spritzschutz 170 kann am elektrischen Anschlusselement 100 bzw. an der Schneidklemme 105b angebracht werden.

Die Schritte 320 und 330 können alternativ auch in umgekehrter Reihenfolge oder parallel zueinander durchgeführt werden. Danach befindet sich das Verfahren in einem Schritt 340 im Endzustand. Das Produkt des Verfahrens 300 ist das elektrische Verbrauchersystem 200 aus Figur 2.

## Patentansprüche

1. Elektrisches Steuergerät (100) für ein Motorkühlmodul (210) mit:
- einem elektrischen Anschlusselement (105) zur nichtlösbaren Verbindung mit einer elektrischen Leitung (220) des elektrischen Verbrauchers (210);
- einer abgedichteten elektrischen Steckverbindung (110) zur lösbaren Verbindung mit einer Stromversorgung (230)
**dadurch gekennzeichnet, dass** die Verbindung der elektrischen Leitung (220) mit dem elektrischen Anschlusselement (105) derart ausgeführt ist, dass eine mangelnde Dichtheit der Verbindung eine Dichtheit des Steuergeräts (100) nicht beeinflusst.

2. Elektrisches Steuergerät (100) nach Anspruch 1, **dadurch gekennzeichnet, dass** das elektrische Anschlusselement (105) einen Schweißanschluss (105) oder eine Schneidklemme (1 05b) umfasst.

3. Elektrisches Steuergerät (100) nach einem der vorangehenden Ansprüche, **gekennzeichnet durch** ein Gehäuse (115, 120) mit einer Aussparung (125), in deren Bereich ein Anschlussträger (130) für das elektrische Anschlusselement (105) und die elektrische Steckverbindung (110) vorgesehen ist, wobei eine erste Dichtung zwischen dem Anschlussträger (130) und dem Gehäuse (115, 120) vorgesehen ist.

4. Elektrisches Steuergerät (100) nach einem der vorangehenden Ansprüche, **dadurch gekennzeichnet, dass** eine zweite Dichtung zwischen dem elektrischen Anschlusselement (105) und dem Anschlussträger (130) vorgesehen ist.

5. Elektrisches Steuergerät (100) nach einem der vorangehenden Ansprüche, **dadurch gekennzeichnet, dass** der Anschlussträger (130) das elektrische Anschlusselement (105) und die elektrische Steckverbindung (110) trägt.

6. Elektrisches Steuergerät (100) nach Anspruch 5, **dadurch gekennzeichnet, dass** der Anschlussträger (130) ein Stanzgitter umfasst.

7. Elektrisches Verbrauchersystem (200), umfassend:
- einen elektrischen Verbraucher (210);
- ein elektrisches Steuergerät (100) nach einem der Ansprüche 1 bis 7; und
- eine nichtlösbar mit dem elektrischen Steuergerät (100) verbundene elektrische Leitung (220) des elektrischen Verbrauchers (210).

8. Elektrisches Verbrauchersystem (200) nach Anspruch 7, **dadurch gekennzeichnet, dass** der elektrische Leiter (220) mit dem elektrischen Verbraucher (210) verschweißt ist.

9. Verfahren (300) zum elektrischen Verbinden eines elektrischen Steuergeräts (100) nach einem der Ansprüche 1 bis 6 mit einem elektrischen Verbraucher (210), mit folgenden Schritten:
- Verbinden (320) einer elektrischen Leitung (220) mit dem elektrischen Verbraucher (210);
- nichtlösbares Verbinden (330) der elektrischen Leitung (220) mit dem elektrischen Steuergerät (100) derart, dass eine mangelnde Dichtheit der Verbindung eine Dichtheit des Steuergeräts (100) nicht beeinflusst.
